# EUROPÄISCHE PATENTANMELDUNG

(11) **EP 1 892 316 A2**
(43) Veröffentlichungstag der Anmeldung: **27.02.2008**
(21) Anmeldenummer: 07113986.9
(22) Anmeldetag: 08.08.2007
(51) Int. Cl.: C23C 14/34, C23C 14/00

(54) **Halogenhaltige Schichten**

(30) Priorität: 25.08.2006 DE 102006039915
(71) Anmelder: Deutsches Zentrum für Luft- und Raumfahrt e.V., 51147 Köln (DE)
(72) Erfinder: Hüppen, Gerd, 53797, Lohmar (DE); Weber, Klaus, 53721, Siegburg (DE); Borath, Roland, 53578, Windhagen (DE)
(74) Vertreter: Jönsson, Hans-Peter

(57) **Zusammenfassung**

Die Erfindung betrifft ein Verfahren zum Abscheiden eines von Halogenen verschiedenen Materials unter Bildung einer halogenhaltigen Schicht und die daraus entstehende halogenhaltige Schicht selbst.

## Beschreibung

Die Erfindung betrifft ein Verfahren zur Herstellung einer halogenhaltigen Schicht auf einem Substrat und die damit hergestellte halogenhaltige Schicht auf dem Substrat.

Bislang werden Substrate, insbesondere Metalloberflächen, wie solche aus Titan oder Nickel dadurch vor Oxidation geschützt, dass beispielsweise Halogene durch Ionenimplantationsverfahren in die Oberfläche durch Beschuss eingelagert werden oder die Oberfläche direkt mit anderen Verfahren mit Halogenen in Kontakt gebracht wird und so Halogene in die Oberfläche eindiffundieren können. Diese Verfahren haben gemeinsam, dass Halogene als solche direkt auf die Oberfläche aufgetragen werden. Diese Verfahren sind besonders nachteilig, da die Halogenkonzentration nur an der äußeren Oberfläche in den ersten wenigen Nanometern Eindringtiefe entsprechend hoch ist und mit zunehmender Eindringtiefe abnimmt (Konzentrationsgradient). Dies ist deshalb besonders nachteilhaft, da der Oxidationsschutz schon bei kleinsten mechanischen Defekten wie Kratzern deutlich nachlässt. Weiterhin wird die Oberfläche des Substrats durch das Einlagern der Halogene verändert. Dies kann im Extremfall zu einer Materialschwächung und dadurch zu vorzeitigem Versagen führen. Durch Erosion kann in manchen Fällen die Oberfläche des Substrats rasch abgetragen werden, wobei das ungeschützte Grundmaterial der Oxidation schutzlos ausgeliefert ist.

DE 3409342 A1 beschreibt einen Prozess, bei dem durch Sputtern halogenhaltige Oxidschichten erzeugt werden. Hierzu sind immer zwei Targets notwendig.

JP 3351054B beschreibt einen Prozess zur Erzeugung von halogenhaltigen Nitridschichten, wobei Metallnitride in einer Halogenatmosphäre abgeschiedene werden.

In der DE 195 39 303 A1 werden metallische Werkstoffe aus einer Titanaluminium-Legierung dadurch vor Oxidation geschützt, dass zunächst Metallpulver entweder direkt halogeniert wird oder mit Halogenidpartikeln vermengt und anschließend das Metallpulver über gekapseltes Strangpressen zu einem Formkörper aus Metall verdichtet wird, der im gesamten Formkörper eine gewisse Halogenkonzentration aufweist.

In der DE 195 39 305 A1 ist ein Verfahren offenbart, bei dem über einen PVD-oder CVD-Prozess Halogene oder beispielsweise Refraktärmetallchloride über die Gasphase auf die Werkstoffoberfläche übertragen werden. Im Prinzip wird also die Werkstoff-Oberfläche mit den Halogenen in Kontakt gebracht, so dass sich an der unmittelbaren Oberfläche des Werkstoffes eine dünne Korrosionsschutzschicht bilden kann.

Die DE 196 27 605 C1 beschreibt ein Verfahren zur Ionenimplantation von Halogenen in die Werkstoffoberfläche.

DE 100 17 187 A1 beschreibt die Behandlung von Oberflächen mit Lösungen von Hydrogenfluoriden.

DE 103 51 946 A1 beschreibt die Behandlung von Oberflächen aus AluminiumLegierungen mit Halogen-haltigen Polymeren.

Auch sind bereits Gasphasen-basierte Prozesse bekannt, bei denen die Atmosphäre halogenhaltig ist.

So beschreibt US 4,310,380 einen Ätzprozess, beim dem eine Siliziumoberfläche in einem Plasmaätzprozess selektiv entfernt wird, wobei die Atmosphäre fluorhaltig ist.

US 5,679,213 A beschreibt einen Prozess zum selektiven Entfernen von Metall, bei dem in einer Brom-haltigen Atmosphäre das Metall in einem Sputter-Prozess mit Argon entfernt wird.

Die Aufgabe der vorliegenden Erfindung besteht also darin, ein Verfahren bereitzustellen, mit dem halogenhaltige Schichten, insbesondere Oxidationsschutzschichten auf Substraten abgeschieden werden können, bei denen der Halogengehalt über die gesamte Dicke der Schichten genau auf einen gewünschten Wert eingestellt werden kann.

Die der Erfindung zugrundeliegende Aufgabe wird in einer ersten Ausführungsform gelöst durch ein Verfahren zur Herstellung einer halogenhaltigen Metallschicht auf einem Substrat, dass dadurch gekennzeichnet ist, dass man
a) ein Edukt enthaltend bis zu 0,1 Atom-% Halogen aus der Gasphase in einer halogenhaltigen Atmosphäre auf dem Substrat abscheidet, oder
b) die halogenhaltige Schicht auf dem Substrat in einem Sputter-Prozess unter Einsatz eines halogen- und aluminiumhaltigen Targets erzeugt.

Ein im Wesentlichen halogenfreies Edukt im Sinne der Erfindung ist ein Material, welches bis zu 5 Atom-% Halogen, insbesondere bis zu 0,1 Atom-%, ganz besonders bevorzugt bis zu 0,01 Atom-% Halogen enthält. Das im Wesentlichen halogenfreie Edukt im Sinne der Erfindung ist das Abzuscheidende. Enthält das halogenfreie Edukt nämlich mehr Halogen als erfindungsgemäß vorgesehen, so kann es zu unvorteilhaften Salzausscheidungen kommen.

Eine halogenhaltige Schicht einerseits oder ein halogenhaltiges Target andererseits im Sinne der Erfindung besteht aus einem Material, welches Halogen als solches und/oder in Form von Salzen aufweist, insbesondere in einer Menge von mindestens 0,001 Atom-%, besonders bevorzugt in einer Menge von mehr als 0,1 Atom-%, und ganz besonders bevorzugt in einer Menge von mindestens 0,5 Atom-%. Ist zu wenig Halogen in der halogenhaltigen Schicht enthalten, so oxidiert das darunter liegende Substrat (beispielsweise Aluminium) durch die Schicht hindurch. Außerdem hat das Halogen die Aufgabe, eine Oxidationsschutzschicht der Oberfläche der halogenhaltigen Schicht auszubilden und bei teilweiser Abnutzung der gebildeten Oxidationsschutzschicht an der Oberfläche diese durch Diffusion des übrigen in der halogenhaltigen Schicht enthaltenen Halogens an die Oberfläche automatisch neu zu bilden ("Halogenreservoir"). Enthält die halogenhaltige Schicht zu wenig Halogen, so kann die Oxidationsschutzschicht auf der halogenhaltigen Schicht nicht mehr effizient bei Abnutzung regeneriert werden. Die halogenhaltige Schicht sollte jedoch vorzugsweise keine oder nur geringe Mengen an Salzen enthalten.

Erfindungsgemäße Substrate bestehen beispielsweise aus Titan, deren Oxidationsbeständigkeit üblicherweise oberhalb von 500 °C stark abnimmt. Durch die Einbringung von Halogenen in eine Schicht auf dem Substrat kann ein Oxidationsschutz bei einer Temperatur von bis zu 1200 °C oder sogar darüber erreicht werden. Bislang bekannte Oxidationsschutz-Schichten, wie beispielsweise Titanaluminium-Legierungen oder Nickel bieten im Vergleich nur Schutz gegen Oxidation bis zu einer Temperatur von bis zu 800 °C.

Mit dem erfindungsgemäßen Verfahren ist es im Unterschied zum Stand der Technik möglich, die Konzentration der Halogene in der halogenhaltigen Schicht beliebig einzustellen. So kann beispielsweise die Konzentration von Halogenen in der halogenhaltigen Schicht über die gesamte Schichtdicke hinweg gleichmäßig eingestellt werden, oder es können auch beliebige Konzentrationsgradienten von Halogen in der halogenhaltigen Schicht eingestellt werden. So ist es prinzipiell auch möglich, die Halogenkonzentration in der halogenhaltigen Schicht auf der dem Substrat zugewandten Seite höher einzustellen als die Konzentration auf der äußeren Oberfläche der halogenhaltigen Schicht. Dies kann beispielsweise dadurch erreicht werden, dass während der Beschichtung der Partialdruck des Halogens verändert wird oder bei halogenhaltigen Quellen (Sputter-Targets) auch gleichzeitig eine im wesentlichen halogenfreie Quelle eingesetzt wird und dann die Leistung für die verschiedenen Quellen unterschiedlich eingestellt wird. Diese Flexibilität hat den Vorteil, dass mit dem erfindungsgemäßen Verfahren das Oxidationsverhalten der Substrate in weiten Grenzen frei bestimmt werden kann.

Vorteilhafterweise kann die Oberfläche des Substrats vor dem Beschichten insbesondere durch Ätzen gereinigt werden. Hierzu wird vorteilhafterweise Flusssäure eingesetzt. Dadurch kann die Oberfläche schon während der Reinigung mit Halogen behandelt werden. Diese Behandlung ist so effektiv, dass die in die Oberfläche eingelagerten Fluor-Atome nur mit starken Oxidationsmitteln, wie beispielsweise Wasserstoffperoxid entfernt werden können. Das Ätzen kann auch vorzugsweise auch als Hochfrequenzätzen durchgeführt werden. Hierbei wird beispielsweise in einem Hochfrequenzplasma geätzt. Dadurch wird die Oberfläche besonders aktiviert, so dass sie gut benetzt wird und die Haftung der Schicht deutlich verbessert werden kann.

Man scheidet als erfindungsgemäße halogenhaltige Schicht vorteilhafterweise eine Aluminium enthaltende Metallschicht ab. Der Aluminiumgehalt liegt vorteilhafterweise in einem Bereich von 2 bis 70 Gew.-%, insbesondere in einem Bereich von 30 bis 70 Gew.%. Dadurch bildet sich eine stabile intermetallische Phase aus, die dennoch einen Oxidationsschutz bewirkt. Besonders geeignet sind Aluminiumlegierungen mit Tantal, Titan und/oder Nickel. Der Gehalt an Tantal, Nickel und/oder Titan liegt vorteilhafterweise unabhängig voneinander zwischen 30 und 70 Gew.%.

Man setzt als halogenhaltige Atmosphäre vorzugsweise eine Fluor, Chlor, Brom und/oder Jod Enthaltende ein. Das halogenhaltige Target kann dementsprechend vorzugsweise Fluor, Chlor, Brom und/oder Jod enthalten. Die Halogene können vorteilhafterweise der Atmosphäre aus der gasförmigen, flüssigen oder festen Phase zugeführt werden. Wahlweise kann die halogenhaltige Atmosphäre auch dadurch erzeugt werden, dass halogenhaltige Salze eingesetzt werden, die während der Durchführung des Verfahrens Halogene abgeben.

Halogenhaltige Targets im Sinne der vorliegenden Erfindung können vorteilhafterweise über einen Sinterprozess, schmelzmetallurgisch oder auch pulvermetallurgisch unter Zugabe eine halogenen Salzes, wie beispielsweise Titanchlorid, Titanfluorid, Molybdänchlorid, Wolframchlorid oder auch Chlorid hergestellt werden. Dabei besteht insbesondere die Möglichkeit, sowohl die Materialien, wie beispielsweise Titanaluminiumlegierungen, reines Titan oder reines Aluminium als Pulver mit einem Halogensalz zu dotieren oder auch zu sintern. Durch den anschließenden Kathodenzerstäubungsprozess wird vorteilhafterweise eine optimale Durchmischung, Halogeneinlagerung und Phasenbildung bei entsprechenden Beschichtungsbedingungen erzeugt. Gegebenenfalls können mit einem variablen oder zweiten, nicht dotierten Target gradierte Schichten hergestellt werden, indem man beispielsweise die Abscheidung des dotierten und des nicht dotierten Targets auf dem Substrat unabhängig von einander regelt. Das Target kann vorteilhafterweise durch heißisostatisches Verpressen von Metallpulvern und halogenhaltigen Substanzen, beispielsweise Halogensalzen hergestellt werden.

Es wurde überraschend gefunden, dass ein Verfahren unter Einsatz eines Targets, welches beispielsweise NaCl enthielt, in einer Schicht resultierte, die zwar Chlor aber keinerlei Natrium enthielt.

Als Substrat setzt man vorteilhafterweise Stahl, Nickel, Titan, Aluminium, Legierungen dieser Metalle oder Keramik ein. Dies gilt insbesondere für Metalle und Keramik, die bei Temperaturen oberhalb von 600 °C oxidieren. Besonders bevorzugt kommen als Substrate so genannte Nickellegierungen, Titanaluminiumlegierungen, Hochtemperaturtitanlegierungen, Hochtemperaturstähle oder Nickelaluminiumlegierungen in Betracht.

Vorteilhafterweise führt man die Abscheidung aus der Gasphase über Kathodenzerstäubung, chemische Dampfabscheidung (CVD) oder Elektronenstrahlverdampfung durch. Bei der Kathodenzerstäubung werden vorteilhafterweise Aluminium-haltige Targets wie beispielsweise Titanaluminium (50 % Ti, 50 % Al) oder Nickelaluminium als Abscheidematerial verwendet. In diesen Sputter-Targets können vorteilhafterweise zusätzlich Legierungselemente wie beispielsweise Molybdän, Chrom, Vanadium oder auch Eisen in einer Menge von 0,1 bis 6 Atom % beigefügt sein. Daneben können diese Sputter-Targets auch vorteilhafterweise Niob in einer Menge in einem Bereich von 10 bis 30 Gew.% enthalten. Der minimale Abstand des Substrats vom Target beträgt vorzugsweise 40 mm und entspricht damit in etwa der freien Weglänge angeregter Argonionen, wobei der maximale Abstand vorteilhafterweise durch die Kammerdimensionen und eine wirtschaftlich sinnvolle Beschichtungsrate begrenzt wird. Dem Trägergas, was beispielsweise Argon sein kann, wird vorteilhafterweise ein oben beschriebenes Halogen oder Halogengemisch zugeführt. Der Druck während der Beschichtung liegt vorteilhafterweise in einem Bereich von 10⁻² bis 10⁻³ mbar, da dies zu einer besonders hohen Abscheiderate führt. Die Beschichtung findet vorteilhafterweise bei einer Temperatur in einem Bereich von 10 bis 600 °C, insbesondere in einem Bereich von 20 bis 100 °C statt. Liegt die Temperatur unterhalb dieser Bereiche, so kann es zu Kondensation der Reaktionsteilnehmer und insbesondere der chemisch sehr reaktiven Halogene im Reaktor kommen und zur Korrosion des Reaktors führen.

Vorteilhafterweise liegt der Partialdruck der Halogene in der halogenhaltigen Atmosphäre in einem Bereich von 10⁻³ bis 10⁻⁹ mbar, besonders bevorzugt in einem Bereich von 5 x 10⁻³ bis 10⁻⁵ mbar. Dies ist insbesondere davon abhängig, wie hoch der Halogengehalt in der abgeschiedenen Schicht sein soll.

In einer weiteren Ausführungsform wird die der Erfindung zugrundeliegende Aufgabe gelöst durch eine halogenhaltige Metallschicht auf einem Substrat, die dadurch gekennzeichnet ist, dass diese eine Schichtdicke in einem Bereich von 0,05 bis 6 µm, insbesondere 0,5 bis 5 µm, ganz besonders bevorzugt in einem Bereich von 2 bis 4 µm aufweist. Die Schicht besteht vorzugsweise im Wesentlichen aus einer Aluminiumlegierung, insbesondere aus einer Tantalalumninid-, Titanaluminium- oder Nickelaluminiumlegierung. Liegt die Schichtdicke oberhalb dieses Bereiches, kann es zu Abplatzungen kommen. Liegt die Schichtdicke jedoch unterhalb dieses Bereiches, so kann das in die Schicht eingelagerte Halogen nicht über eine ausreichend lange Zeit an die Oberfläche diffundieren und die Oxidationsschutzschicht regenerieren.

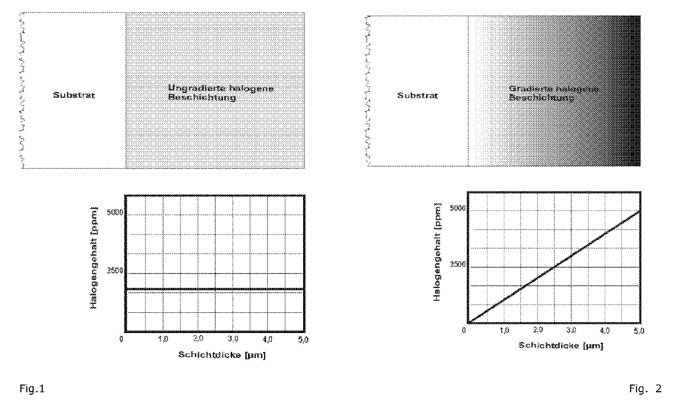

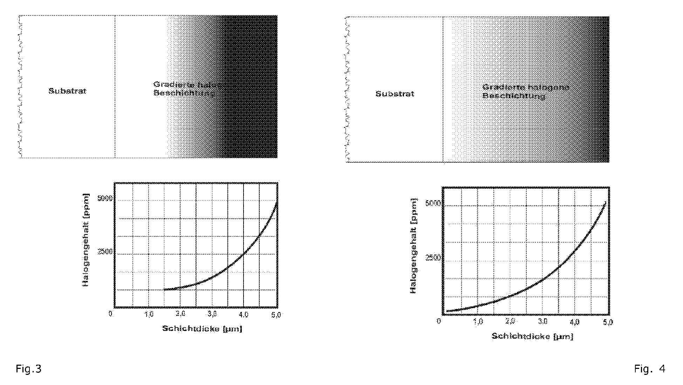

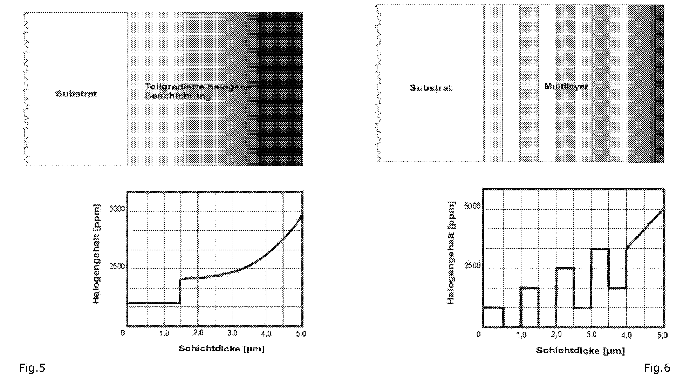

Während des Kondensationsvorgangs auf der Substratoberfläche lagern sich die Halogene vorteilhafterweise in die Beschichtung ein, wobei die eingelagerte Menge insbesondere abhängig vom Partialdruck der Gase und gegebenenfalls der Beschussenergie ist. Der Halogengehalt kann also beispielsweise über den Partialdruck eingestellt werden. Hierbei besteht die Möglichkeit, die Halogeneinlagerung sowohl gradiert als auch gleichmäßig in die Schicht einzubringen. Es lässt sich also vorteilhafterweise sowohl die Abscheiderate als auch die Dotierung der abgeschiedenen Schicht gradiert oder ungradiert in allen Varianten während des Prozesses verändern. So kann der Halogengehalt innerhalb der Schicht beispielsweise konstant gehalten werden (vgl. Fig. 1) Wahlweise kann jedoch auch der Gehalt an Halogenen vom Substrat aus in Richtung der äußeren Oberfläche der Schicht linear ansteigen (vgl. Fig. 2). Die Konzentration der Halogene innerhalb der Schicht kann jedoch auch so eingestellt werden, dass die Schicht zunächst ohne Halogene abgeschieden wird und im späteren Verlauf der Schicht Richtung äußere Oberfläche der Schicht die Konzentration der Halogene progressiv oder exponentiell zunimmt (vgl. Fig. 3). Genauso gut kann jedoch der Konzentrationsverlauf der Halogene innerhalb der Schicht auch so eingestellt werden, dass die Konzentration von der Substratseite zur äußeren Oberfläche der Schicht direkt progressiv oder exponentiell ansteigt (vgl. Fig. 4). Die Halogenkonzentration kann jedoch auch so eingestellt werden, dass vom Substrat aus gesehen zunächst eine bestimmte definierte Halogenkonzentration vorliegt und im späteren Schichtdickenverlauf in Richtung der äußeren Oberfläche der Schicht ab einem bestimmten Punkt die Konzentration der Halogene exponentiell zunimmt (vgl. Fig. 5). Auch kann die Konzentration der Halogene so innerhalb der Schicht gestaltet sein, dass sich eine so genannte Multilayer-Konfiguration ergibt. Dies bedeutet, dass ausgehend vom Substrat verschiedene Konzentrationsbereiche mit einer jeweils definierter Konzentration, die in benachbarten Bereichen unterschiedlich ist, abwechseln (vgl. Fig. 6). Dies kann vorzugsweise so geschehen, dass die Konzentration insgesamt in Richtung äußere Oberfläche der Schicht zunimmt. Die Schicht weist insbesondere im Mittel über die gesamte Schichtdicke hinweg besonders bevorzugt einen Halogengehalt in einem Bereich von 100 bis 50000 ppm, ganz besonders bevorzugt in einem Bereich von 500 bis 20000 ppm, noch mehr bevorzugt mindestens 1500 ppm auf. Unterhalb dieses Bereiches nimmt der Korrosionsschutz so sehr ab, dass er nicht mehr gewährleistet werden kann. Oberhalb dieses Bereiches wird Halogen in das Gitter eingelagert und führt zu amorphen Strukturen oder auch Salzen. Eine Versprödung kann dann eintreten.

Das Substrat ist vorteilhafterweise metallisch, insbesondere aus Stahl, Nickel, Titan, Aluminium und Legierungen dieser Materialien aber auch Keramik.

### Ausführungsbeispiel:

Es wurde mit Hilfe von Gleichstrom-Kathodenzerstäubung ("DC-Sputtern") eine Chlor enthaltende Titanaluminiumschicht mit einer Schichtdicke von 4 µm hergestellt. Der Argondruck im Rezipient betrug 5 x 10⁻³ mbar. Der Partialdruck von Chlor betrug 5 x 10⁻⁴ mbar. Der Partialdruck von Chlor wurde mit Hilfe eines Masseflussreglers eingestellt. Die Argonionen wurden mit einer Gleichspannung von 400 V zum Target beschleunigt. Das Target bestand aus einer Legierung aus 50 % Aluminium und 50 % Titan. Die Distanz zwischen dem Substrat aus herkömmlichem Stahl und dem Target betrug 100 mm. Bei einer Targetleistung von etwa 3 kW und einer Beschichtungsdauer von etwa 2,5 h konnte eine Schichtdicke von 4 µm erzielt werden.

Mit Hilfe von Rasterelektronenmikroskopie in Verbindung mit einer quantitativen EDX-Analyse wurde ein Tiefenprofil der Zusammensetzung gemessen. Dabei wurde festgestellt, dass über die gesamte Schichtdicke hinweg der Chlorgehalt in der Titanaluminiumlegierung etwa 2 Atom-% (20000 ppm) betrug.

## Patentansprüche

1. Verfahren zur Herstellung einer halogenhaltigen Metallschicht auf einem Substrat, **dadurch gekennzeichnet, dass** man
a) ein Edukt enthaltend bis zu 0,1 Atom-% Halogen aus der Gasphase in einer halogenhaltigen Atmosphäre auf dem Substrat abscheidet, oder
b) die halogenhaltige Schicht auf dem Substrat in einem Sputter-Prozess unter Einsatz eines halogen- und aluminiumhaltigen Targets erzeugt.

2. Verfahren gemäß Anspruch 1, **dadurch gekennzeichnet, dass** man eine Aluminium enthaltende Metallschicht abscheidet.

3. Verfahren gemäß Anspruch 1, **dadurch gekennzeichnet, dass** man eine fluor-, chlor-, brom- und/oder jodhaltige Atmosphäre einsetzt.

4. Verfahren gemäß Anspruch 1, **dadurch gekennzeichnet, dass** man ein Stahl, Nickel, Titan, Aluminium, Legierungen dieser Metalle oder Keramik enthaltendes Substrat einsetzt.

5. Verfahren gemäß Anspruch 1, **dadurch gekennzeichnet, dass** man die Abscheidung aus der Gasphase über Kathodenzerstäubung, chemische Dampfabscheidung oder Elektronenstrahlverdampfung durchführt.

6. Verfahren gemäß Anspruch 1, **dadurch gekennzeichnet, dass** man einen Partialdruck der Halogene in der halogenhaltigen Atmosphäre in einem Bereich von 10⁻³ bis 10⁻⁹ mbar einstellt.

7. Halogenhaltige Metallschicht auf einem Substrat, **dadurch gekennzeichnet, dass** diese eine Schichtdicke in einem Bereich von 0,05 bis 6 µm, insbesondere 0,5 bis 5 µm aufweist.

8. Schicht gemäß Anspruch 7, **dadurch gekennzeichnet, dass** diese im Wesentlichen aus einer Aluminiumlegierung, insbesondere aus ein TiAl- oder NiAl-Legierung besteht.

9. Schicht gemäß Anspruch 7, **dadurch gekennzeichnet, dass** diese einen Halogengehalt in einem Bereich von 10 bis 50000 ppm aufweist, insbesondere, dass das Halogen ausgewählt ist aus der Gruppe Fluor, Chlor und/oder Brom.

10. Schicht gemäß Anspruch 7, **dadurch gekennzeichnet, dass** das Substrat ein Metallsubstrat umfasst, insbesondere ein Substrat aus Stahl, Nickel, Titan, Aluminium, Legierungen dieser Materialien oder Keramik.
